# EUROPEAN PATENT SPECIFICATION

(11) **EP 2 833 426 B1**
(45) Date of publication and mention of the grant of the patent: **04.09.2019**
(21) Application number: 14154706.7
(22) Date of filing: 11.02.2014
(51) Int. Cl.: G02F 1/1333, H01L 51/52, H01L 27/32

(54) **Flexible display device**
Flexible Anzeigevorrichtung
Dispositif d'affichage flexible

(30) Priority: 31.07.2013 KR 20130091008
(43) Date of publication of application: 04.02.2015
(73) Proprietor: Samsung Display Co., Ltd., Gyeonggi-do (KR)
(72) Inventor: Kim, Jinkyu, Chungcheongbuk-do (KR); Beom, Jingab, Chungcheongnam-do (KR); Shim, Jinbo, Gyeonggi-do (KR); Jung, Soyoun, Seoul (KR); Ji, Yujin, Gyeonggi-do (KR)
(74) Representative: Taor, Simon Edward William

(56) References cited:
- EP-A1- 2 151 878
- EP-A2- 2 541 371
- WO-A2-2012/173397
- JP-A- 2002 297 066
- US-A1- 2012 181 929

## Description

The disclosure relates to a display device, and in particular, to a flexible display device.

Recently, a bendable or foldable display device (hereinafter, referred as to a "flexible display device") has been developed. The flexible display device includes a flexible display panel and several functional parts.

The functional parts are disposed on the flexible display panel. The functional parts may be bended or folded along with the flexible display panel.

Example embodiments of the inventive concept provide a flexible display device capable of preventing a failure from occurring.

The flexible display device of the invention includes a flexible display panel, a first outer member disposed on a surface of the flexible display panel, and a first adhesive member attaching the first outer member to the flexible display panel.

The flexible display panel includes a folding region and a peripheral region. The first adhesive member includes an ultraviolet curable resin. The first adhesive member includes first and second regions respectively corresponding to the folding and peripheral regions. The ultraviolet curable resin of the first region has a conversion rate lower than a conversion rate of the ultraviolet curable resin of the second region.

The conversion rate of the ultraviolet curable resin of the first region ranges from about 50% to about 80%, and the conversion rate of the ultraviolet curable resin of the second region ranges from about 85% to 100%.

The ultraviolet curable resin may include at least one of urethane acrylate-based resins, epoxy acrylate-based resins, polyester-based resins, or polycarbonate-based resins.

The first adhesive member has a thickness ranging from about 10 µm to about 200 µm. The flexible display panel may be folded at the folding region with a curvature radius of about 0.5 to about 10 mm.

The flexible display device may further include a second outer member disposed on another surface of the flexible display panel, and a second adhesive member attaching the second outer member to the flexible display panel. The second adhesive member may include an ultraviolet curable resin.

The second adhesive member may include third and fourth regions corresponding to the folding and peripheral regions, respectively. The ultraviolet curable resin of the third region may have a conversion rate lower than a conversion rate of the ultraviolet curable resin of the fourth region.

According to an aspect of the invention, there is provided a flexible display device as set out in claim 1. Preferred features of this aspect are set out in claims 2 to 7.

Example embodiments will be more clearly understood from the following brief description taken in conjunction with the accompanying drawings. The accompanying drawings represent non-limiting, example embodiments as described herein.
FIG. 1 is a perspective view of a flexible display device according to example embodiments.
FIG. 2A is a side view illustrating an unfolded structure of the flexible display device according to example embodiments.
FIG. 2B is a side view illustrating a folded structure of the flexible display device according to example embodiments.
FIG. 3 is an equivalent circuit diagram of a pixel in a flexible display panel according to example embodiments.
FIG. 4 is a layout diagram of the pixel in the flexible display panel according to example embodiments.
FIG. 5 is a sectional view taken along a line I-I' of FIG. 4.
FIG. 6 is a sectional view taken along a line II-II' of FIG. 4.
FIG. 7 is a side view illustrating an unfolded structure of a flexible display device according to example embodiments.
FIG. 8 is an enlarged view of a portion of FIG. 7.
FIG. 9 is a side view illustrating an unfolded structure of a flexible display device according to example embodiments.

It should be noted that these figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

Example embodiments will now be described more fully with reference to the accompanying drawings, in which example embodiments are shown. Example embodiments may, however, be embodied in many different forms and should not be construed as being limited to the embodiments set forth herein; rather, these embodiments are provided so that this disclosure will be thorough and complete, and will fully convey the concept of example embodiments to those of ordinary skill in the art. In the drawings, the thicknesses of layers and regions may be exaggerated for clarity. Like reference numerals in the drawings generally denote like elements, and thus their description will be omitted.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. As used herein the term "and/or" includes any and all combinations of one or more of the associated listed items. Other words used to describe the relationship between elements or layers should be interpreted in a like fashion (e.g., "between" versus "directly between," "adjacent" versus "directly adjacent," "on" versus "directly on").

It will be understood that, although the terms "first", "second", and the like may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises", "comprising", "includes" and/or "including," if used herein, specify the presence of stated features, integers, steps, operations, elements and/or components, but do not preclude the presence or addition of one or more other features, integers, steps, operations, elements, components and/or groups thereof. Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

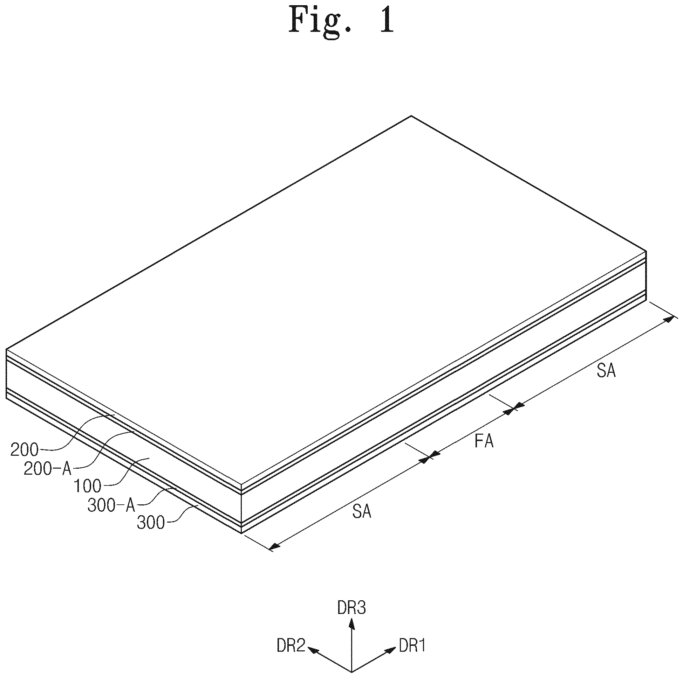

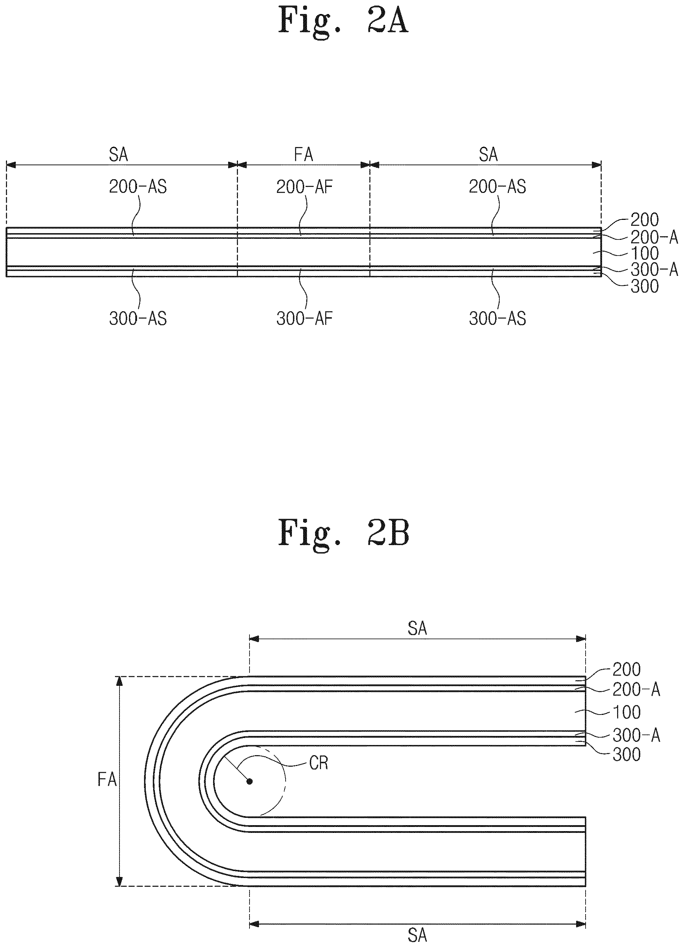

FIG. 1 is a perspective view of a flexible display device according to example embodiments. FIG. 2A is a side view illustrating an unfolded structure of the flexible display device according to example embodiments, and FIG. 2B is a side view illustrating a folded structure of the flexible display device according to example embodiments.

According to example embodiments, as shown in FIGS. 1, 2A and 2B, a flexible display device (hereinafter, also referred as to a "display device") includes a flexible display panel 100, a first outer member 200, and a first adhesive member 200-A.

The flexible display panel 100 may include a flexible substrate, signal lines disposed on the flexible substrate, and pixels electrically connected to the signal lines. An image may be displayed by the pixels, based on signals transmitted through the signal lines. The image may be displayed through a surface of the flexible display panel 100.

The flexible display panel 100 may be bent or rolled to form a substantially curved surface, and it may be folded at a specific region. When viewed in a plane defined by a first direction DR1 and second direction DR2, the flexible display panel 100 may include a folding region FA and a peripheral region SA. In the example shown in FIGS. 1, 2A and 2B, the flexible display panel 100 may include a pair of the peripheral regions SA and one folding region FA therebetween.

Each of the folding and peripheral regions FA and SA may include some of the pixels. Further, the folding region FA and the peripheral regions SA may be configured to display an image without any discontinuity at interfaces between the folding and peripheral regions FA and SA. The folding region FA may be defined as a foldable region of the flexible display panel 100, while each of the peripheral regions SA may be defined as a region adjacent to the folding region FA. The peripheral regions SA may be flat or gently curved.

As shown in FIG. 2B, the flexible display panel 100 may be fully folded in such a way that the pair of the peripheral regions SA face each other. A curvature radius CR of the flexible display panel 100 at the folding region FA may range from about 0.5 mm to about 10 mm.

The first outer member 200 may be disposed on the surface of the flexible display panel 100. The first outer member 200 may include at least one of a polarizing plate, a touch screen, or a protection member. The polarizing plate, the touch screen, and the protection member may include a flexible element, such as a plastic substrate or a plastic film.

Further, at least two outer members may be disposed on the surface of the flexible display panel 100. In addition, the first outer member 200 may further include a functional coating layer, such as anti-fingerprint coating layer or an anti-reflection coating layer.

The first adhesive member 200-A may be disposed between the flexible display panel 100 and the first outer member 200 to adhere the first outer member 200 to the flexible display panel 100.

The first adhesive member 200-A comprises an ultraviolet curable resin. The ultraviolet curable resin may include at least one of urethane acrylate-based resins, epoxy acrylate-based resins, polyester-based resins, or polycarbonate-based resins.

In some embodiments, the first adhesive member includes a mixture of silicone resin and acrylic resin.

A radical polymerization may start, when ultraviolet light is incident into the ultraviolet curable resin. Due to the incidence of the ultraviolet light, carbons in the ultraviolet curable resin may be changed from double bonds to single bonds. One cut chain of a double bond of carbons constituting a monomer or oligomer may form a polymer chain along with that of other monomer or oligomer. The more the polymer chain, the higher the cure level of the ultraviolet curable resin. The cure level of the ultraviolet curable resin may be proportional to the UV exposure time.

The first adhesive member 200-A includes at least two regions, whose cure levels are different from each other. The first adhesive member 200-A includes a first region 200-AF corresponding to the folding region FA and a second region 200-AS corresponding to the peripheral region.

In terms of a cured level, the first region 200-AF is lower than the second region 200-AS. Accordingly, it is possible to maintain the flexibility of the first region 200-AF, and thus, the first region 200-AF is not broken even when the flexible display panel 100 is folded. The first region 200-AF may have a tensile strain lower than the second region 200-AS.

A conversion rate of the first region 200-AF is lower than that of the second region 200-AS, when the first region 200-AF has a lower cure level than the second region 200-AS as described above. For example, the conversion rate may represent how many carbons in the ultraviolet curable resin are changed from double bonds to single bonds.

The conversion rate may be measured by analyzing the first adhesive member 200-A using a Fourier transform infrared spectrometer (FT-IR) method. In example embodiments, the first region 200-AF may have a conversion rate ranging from about 50% to about 80%, and this may make it possible to achieve an adhesive strength higher than a desired value and maintain the flexible property.

The second region 200-AS may have a conversion rate ranging from about 85% to 100%. The first adhesive member 200-A may have a thickness ranging from about 10 µm to about 200 µm.

As shown in FIGS. 1, 2A, and 2B, the display device may further include a second outer member 300 and a second adhesive member 300-A.

The second outer member 300 may be disposed on other surface of the flexible display panel 100 facing the surface of the flexible display panel 100 in a thickness direction DR3.

The second outer member 300 may include at least one of a polarizing plate or a protection member. Further, two or more outer members may be disposed on the other surface of the flexible display panel 100.

The second adhesive member 300-A may be disposed between the flexible display panel 100 and the second outer member 300 to attach the second outer member 300 to the flexible display panel 100.

The second adhesive member 300-A may include an ultraviolet curable resin. The second adhesive member 300-A may include at least two regions, whose cure levels are different from each other. For example, the second adhesive member 300-A may include a third region 300-AF corresponding to the folding region FA and a fourth region 300-AS corresponding to the peripheral region.

In terms of a cured level, the third region 300-AF may be lower than the fourth region 300-AS. The third region 300-AF may have a conversion rate ranging from about 50% to about 80%, while the fourth region 300-AS may have a conversion rate ranging from about 85% to 100%. The second adhesive member 300-A may have a thickness ranging from about 10 µm to about 200 µm.

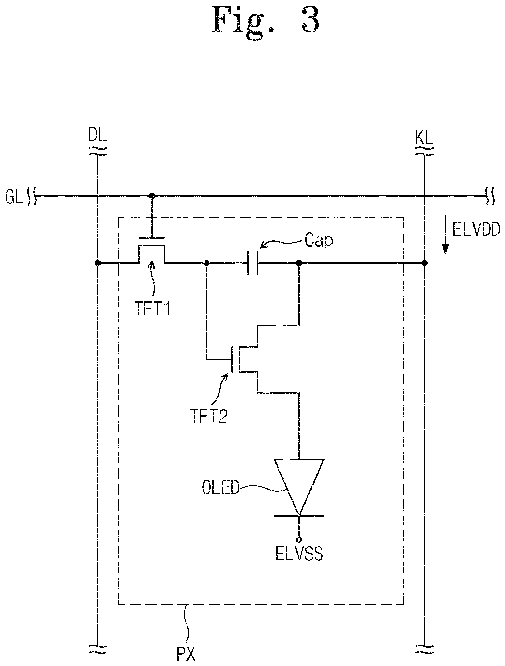

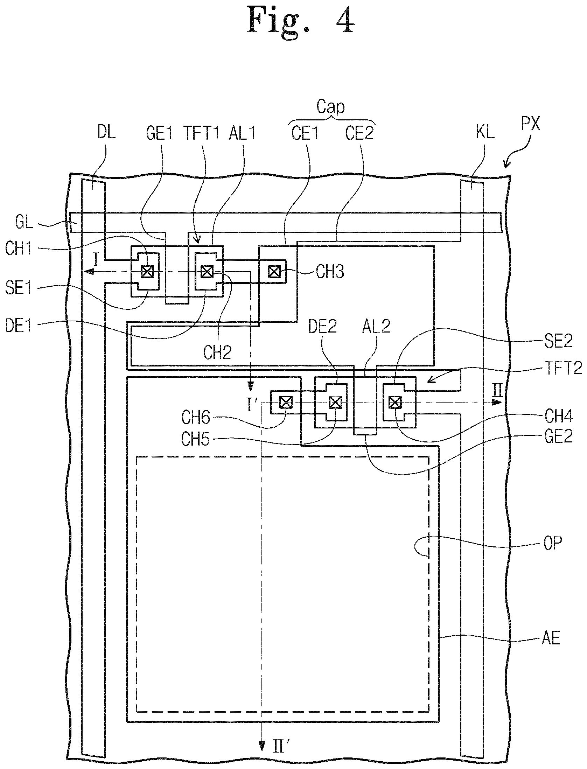

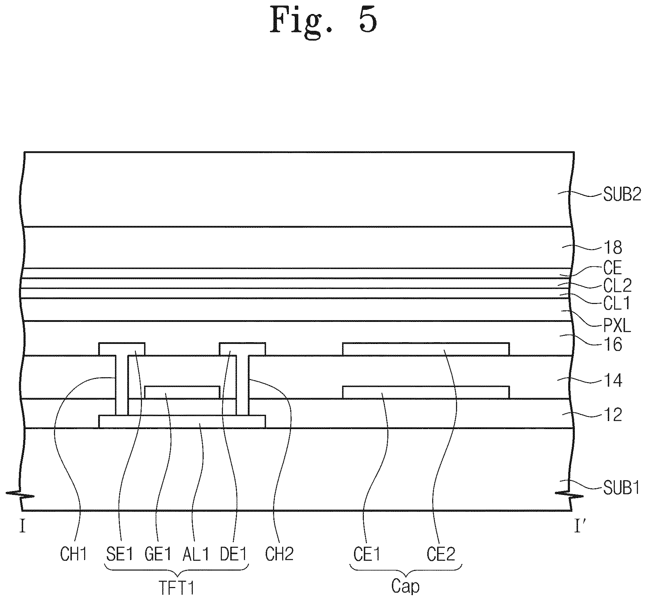

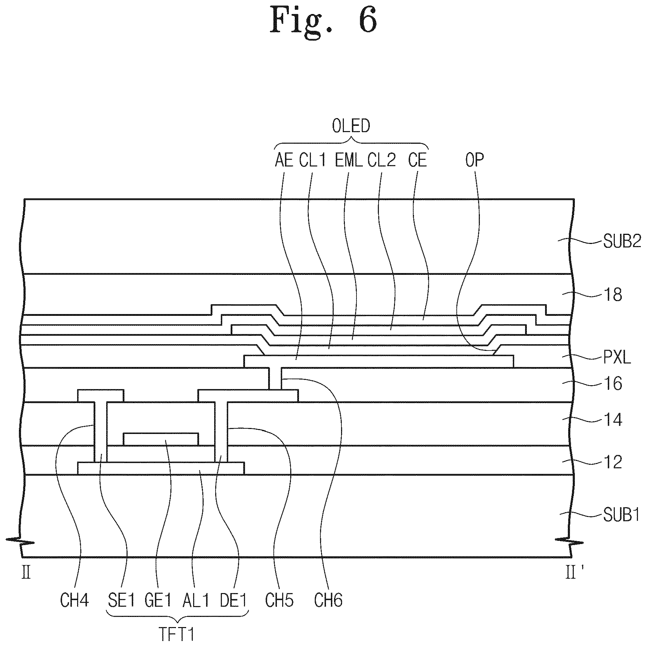

FIG. 3 is an equivalent circuit diagram of a pixel in a flexible display panel according to example embodiments. FIG. 4 is a layout diagram of the pixel in the flexible display panel according to example embodiments. FIG. 5 is a sectional view taken along a line I-I' of FIG. 4, and FIG. 6 is a sectional view taken along a line II-II' of FIG. 4.

Image devices including pixels may be changed depending on the kind of flexible display panel. For example, for an organic light emitting display panel, an organic light emitting diode may be used for the image device, and for an electrophoresis display panel, two electrodes and electrophoresis particles may be used to realize the image device. For an electrowetting display panel, two electrodes and electric ink may be used to realize the image device. Hereinafter, an organic light emitting display panel (hereinafter, referred to as a "display panel") will be described with reference to FIGS. 3 through 5 as an example of flexible display panel.

The display panel 100 may include a base substrate SUB1, signal lines GL and DL, pixels PX, and an encapsulating substrate SUB2. In FIGS. 3 through 6, one of the pixel PX is illustrated as an example.

The base substrate SUB1 may include a flexible plastic substrate. The pixel PX may include at least one transistor, at least one capacitor, and an organic light emitting diode. The signal lines GL and DL may include a gate line GL, a data line DL, and a power line KL. The encapsulating substrate SUB2 may also include a flexible plastic substrate. The encapsulating substrate SUB2 may be replaced with an encapsulating thin film in some embodiments.

The gate line GL, the data line DL, the power line KL, and the pixel PX may be disposed on the base substrate SUB1. The pixel PX may include a first thin film transistor TFT1, a second thin film transistor TFT2, a capacitor Cap, and an organic light emitting diode OLED.

A semiconductor pattern AL1 (hereinafter, referred as to a "first semiconductor pattern") for the first thin film transistor TFT1 and a semiconductor pattern AL2 (hereinafter, referred as to a "second semiconductor pattern") for the second thin film transistor TFT2 may be disposed on the base substrate SUB1. A first insulating layer 12 may be provided on the base substrate SUB1 to cover the first semiconductor pattern AL1 and the second semiconductor pattern AL2. The first insulating layer 12 may include an organic and/or inorganic layer. The first insulating layer 12 may include a plurality of thin films.

A control electrode GE1 (hereinafter, referred as to a "first control electrode") for the first thin film transistor TFT1 and a control electrode GE2 (hereinafter, referred as to a "second control electrode") for the second thin film transistor TFT2 may be disposed on the first insulating layer 12. A first electrode CE1 of the capacitor Cap may be disposed on the first insulating layer 12.

A second insulating layer 14 may be disposed on the first insulating layer 12 to cover the first and second control electrodes GE1 and GE2 and the first electrode CE1 of the capacitor. The second insulating layer 14 may include an organic and/or inorganic layer. The second insulating layer 14 may include a plurality of thin films.

An input electrode SE1 (hereinafter, referred as to a "first input electrode") and output electrode DE1 (hereinafter, referred as to a "first output electrode") for the first thin film transistor TFT1 may be disposed on the second insulating layer 14. An input electrode SE2 (hereinafter, referred as to a "second input electrode") and output electrode DE2 (hereinafter, referred as to a "second output electrode") for the second thin film transistor TFT2 may be disposed on the second insulating layer 14. A second electrode CE2 of the capacitor Cap may be disposed on the second insulating layer 14.

The first input electrode SE1 and the first output electrode DE1 may be connected to the first semiconductor pattern AL1 via a first through hole CH1 and a second through hole CH2, respectively, that are formed to penetrate the first insulating layer 12 and the second insulating layer 14. The first output electrode DE1 may be connected to the first electrode CE1 via a third through hole CH3 penetrating the second insulating layer 14. The second input electrode SE2 and the second output electrode DE2 may be connected to the second semiconductor pattern AL2 via a fourth through hole CH4 and a fifth through hole CH5, respectively, that are formed to penetrate the first insulating layer 12 and the second insulating layer 14. In some embodiments, the first thin film transistor TFT1 and the second thin film transistor TFT2 may be configured to have a bottom-gate structure.

A third insulating layer 16 may be disposed on the second insulating layer 14 to cover the first input electrode SE1, the first output electrode DEi, the second input electrode SE2, and the second output electrode DE2. The third insulating layer 16 may include an organic and/or inorganic layer. The third insulating layer 16 may include a plurality of thin films.

A pixel-defining layer PXL and the organic light emitting diode OLED may be disposed on the third insulating layer 16. The organic light emitting diode OLED may include an anode AE, a first common layer CL1, an organic light emitting layer EML, a second common layer CL2, and a cathode CE, which may be sequentially stacked on the third insulating layer 16. The anode AE may be connected to the second output electrode DE2 via a sixth through hole CH6 that is formed to penetrate the third insulating layer 16. Depending on a light-emitting direction of the organic light emitting diode OLED, the anode AE and the cathode CE may be provided to have positions different from those shown in FIG. 6.

The anode AE may be provided on the third insulating layer 16. The pixel-defining layer PXL may include an opening OP exposing the anode AE. The first common layer CL1 may be provided on the anode AE. The first common layer CL1 may extend a light-emitting region delimited by the opening OP to a non-light-emitting region. For example, the first common layer CL1 may be wholly provided on the top surface of the base substrate SUB1. The first common layer CL1 may include a hole injection layer. The first common layer CL1 may further include a hole transport layer.

The organic light emitting layer EML may be provided on the first common layer CL1. The organic light emitting layer EML may be located on the opening OP. The second common layer CL2 may be provided on the organic light emitting layer EML. The second common layer CL2 may be wholly provided on the top surface of the base substrate SUB1, like the first common layer CL1. The second common layer CL2 may include an electron injection layer. The second common layer CL2 may further include an electron transport layer. The cathode CE may be provided on the second common layer CL2. The cathode CE may be wholly provided on the top surface of the base substrate SUB1.

A fourth insulating layer 18 may be provided on the cathode CE. The fourth insulating layer 18 may include an organic and/or inorganic layer. The fourth insulating layer 18 may include a plurality of thin films. The encapsulating substrate SUB2 may be provided on the fourth insulating layer 18.

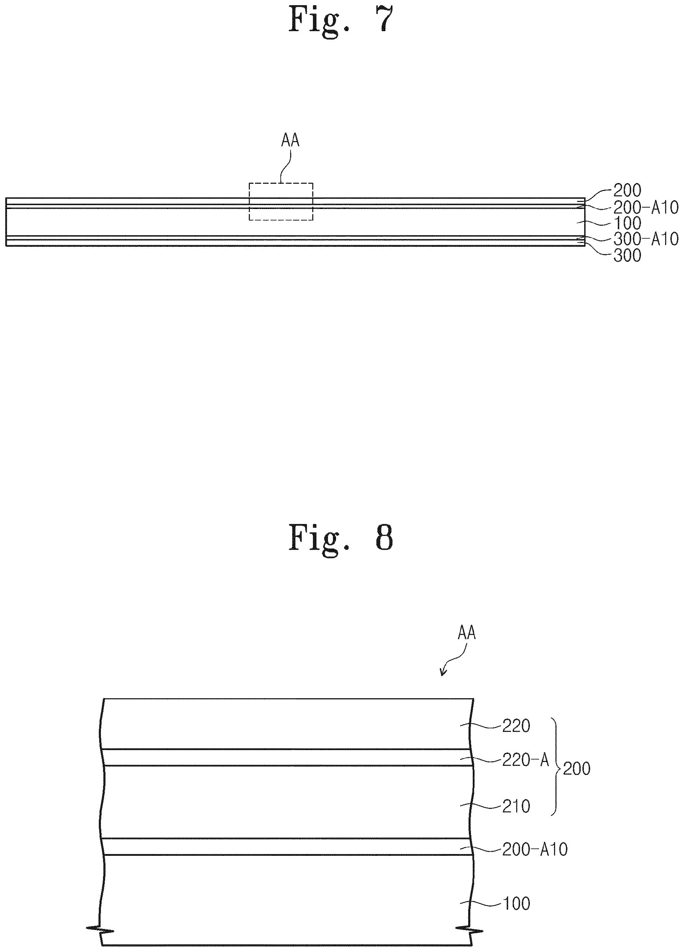

FIG. 7 is a side view illustrating an unfolded structure of a flexible display device according to example embodiments. FIG. 8 is an enlarged view of a portion of FIG. 7. Hereinafter, a flexible display device will be described with reference to FIGS. 7 and 8. For the sake of brevity, the elements and features of this example embodiment that are similar to those previously shown and described will not be described in much further detail.

A flexible display device (hereinafter, referred as to a "display device") may include the flexible display panel 100, the first outer member 200, and the first adhesive member 200-A10.

The flexible display panel 100 may be bent, folded, or rolled to form a substantially curved surface. The flexible display panel 100 may be an organic light emitting display panel, an electrophoresis display panel, or an electrowetting display panel.

The flexible display panel 100 may be configured to display an image through a surface thereof. The first outer member 200 may be provided on the surface of the flexible display panel 100. The first adhesive member 200-A10 may be disposed between the flexible display panel 100 and the first outer member 200 to attach the first outer member 200 to the flexible display panel 100.

The first adhesive member 200-A10 may include a mixture of silicone resin and acrylic resin. The first adhesive member 200-A10 may contain a silicone resin, which may be formed by catalytically reacting poly dimethyl siloxane (PDMS) with silicate resin at high temperature.

The acrylic resin may contain methyl acrylate, ethyl acrylate, n-propyl acrylate, isopropyl acrylate, n-butyl acrylate, t-butyl acrylate, sec-butyl acrylate, pentyl acrylate, 2-ethylhexyl acrylate, n-octyl acrylate, iso-octyl acrylate, iso-nonyl acrylate, isobornyl acrylate, or lauryl acrylate as a monomer component.

The first adhesive member 200-A10 may contain about 40-60 part by weight of silicone resin and about 60-40 part by weight of acrylic resin. For example, the first adhesive member 200-A10 may include about 50 part by weight of silicone resin and about 50 part by weight of acrylic resin. The first adhesive member 200-A10 may have a thickness ranging from about 10 µm to about 200 µm.

Even when the display device is bent, folded, and/or rolled, the first adhesive member 200-A10 may not be damaged because it has both of the flexible property of the silicone resin and the adhesive property of the acrylic resin.

As shown in FIG. 8, the first outer member 200 may include a touch screen 210 disposed on the first adhesive member 200-A10 and a protection member 220 disposed on the touch screen 210. The protection member 220 may include a flexible plastic film. In addition, the protection member 220 may further include a functional coating layer, such as anti-fingerprint coating layer or an anti-reflection coating layer.

The touch screen 210 and the protection member 220 may be jointed to each other by an adhesive member 220-A. The adhesive member 220-A may be formed of the same material as the first adhesive member 200-A10.

Referring back to FIG. 7, the display device may further include a second outer member 300 and a second adhesive member 300-A10. The second outer member 300 may be disposed on the other side of the flexible display panel 100. The second adhesive member 300-A10 may be formed of the same material as the first adhesive member 200-A10.

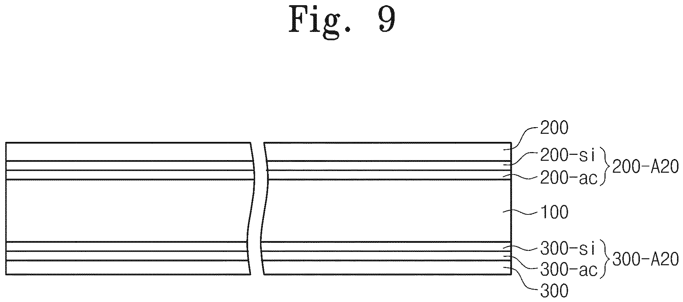

FIG. 9 is a side view illustrating an unfolded structure of a flexible display device according to example embodiments. Hereinafter, the flexible display device will be described with reference to FIG. 9. For the sake of brevity, the elements and features of this example that are similar to those previously shown and described will not be described in much further detail.

A flexible display device (hereinafter, referred as to a "display device") may include the flexible display panel 100, the first outer member 200, and a first adhesive member 200-A20.

The flexible display panel 100 may be configured to display an image through a surface thereof. The first outer member 200 may be disposed on the surface of the flexible display panel 100. The first adhesive member 200-A20 may be disposed between the flexible display panel 100 and the first outer member 200 to attach the first outer member 200 to the flexible display panel 100.

The first adhesive member 200-A20 may include a silicone resin layer 200-si and an acrylic resin layer 200-ac. The silicone resin layer 200-si may contain a silicone resin, which may be formed by catalytically reacting poly dimethyl siloxane (PDMS) with silicate resin at high temperature.

The acrylic resin layer 200-ac may contain methyl acrylate, ethyl acrylate, n-propyl acrylate, isopropyl acrylate, n-butyl acrylate, t-butyl acrylate, sec-butyl acrylate, pentyl acrylate, 2-ethylhexyl acrylate, n-octyl acrylate, iso-octyl acrylate, iso-nonyl acrylate, isobornyl acrylate, or lauryl acrylateas a monomer component.

The first adhesive member 200-A10 may have a thickness ranging from about 10 µm to about 200 µm. A ratio in thickness of the silicone resin layer 200-si to the acrylic resin layer 200-ac may range from about 6:4 to about 4:6. The silicone resin layer 200-si and the acrylic resin layer 200-ac may have the same thickness.

Even when the display device is bent, folded, and/or rolled, the first adhesive member 200-A20 may not be damaged because it has both of the flexible property of the silicone resin and the adhesive property of the acrylic resin.

As shown in FIG. 9, the display device may further include the second outer member 300 and a second adhesive member 300-A20. The second outer member 300 may be disposed on the other side of the flexible display panel 100. The second adhesive member 300-A20 may be formed of the same material as the first adhesive member 200-A20.

According to example embodiments, the first adhesive member includes a first region corresponding to the folding region. The first region of the first adhesive member is more flexible than other regions. In other words, the cure level of the first region is lower than the other regions. Accordingly, even if the flexible display device is folded, it is possible to prevent the first adhesive member from being broken. Further, the flexible display device can be normally operated, even when it is repeatedly folded and unfolded.

The first adhesive member has both the flexible property of the silicone resin and the adhesive property of the acrylic resin, and thus, even when the flexible display device is bent, folded, and/or rolled, it is possible to prevent the first adhesive member from being broken.

As discussed, embodiments of the invention provide a flexible display device, comprising: a flexible display panel including a folding region and a peripheral region; a first outer member disposed on a surface of the flexible display panel; and a first adhesive member arranged to attach the first outer member to the flexible display panel, the first adhesive member comprising an ultraviolet curable resin, and first and second regions respectively corresponding to the folding and peripheral regions, wherein the ultraviolet curable resin of the first region has a conversion rate lower than a conversion rate of the ultraviolet curable resin of the second region. In some embodiments, the first adhesive member includes a mixture of silicone resin and acrylic resin

While example embodiments of the inventive concepts have been particularly shown and described, it will be understood by one of ordinary skill in the art that variations in form and detail may be made therein without departing from the scope of the attached claims.

## Claims

1. A flexible display device, comprising:
a flexible display panel (100) including a folding region (FA) and a peripheral region (SA);
a first outer member (200) disposed on a surface of the flexible display panel; and
a first adhesive member (200-A) arranged to attach the first outer member to the flexible display panel, the first adhesive member comprising an ultraviolet curable resin, and first and second regions (200-AF, 200-AS) respectively corresponding to the folding and peripheral regions,
wherein the ultraviolet curable resin of the first region has a conversion rate lower than a conversion rate of the ultraviolet curable resin of the second region.

2. The flexible display device of claim 1, wherein the conversion rate of the ultraviolet curable resin of the first region ranges from about 50% to about 80%, and
the conversion rate of the ultraviolet curable resin of the second region ranges from about 85% to 100%.

3. The flexible display device of claim 2, wherein the ultraviolet curable resin includes at least one of an urethane acrylate-based resin, an epoxy acrylate-based resin, a polyester-based resin, or a polycarbonate-based resin.

4. The flexible display device of claim 2 or 3, wherein the first adhesive member has a thickness ranging from about 10 µm to about 200 µm.

5. The flexible display device of any one of claims 2 to 4, wherein the flexible display panel is folded at the folding region with a curvature radius of about 0.5 to about 10 mm.

6. The flexible display device of any one of claims 1 to 5, further comprising:
a second outer member disposed on another surface of the flexible display panel; and
a second adhesive member attaching the second outer member to the flexible display panel and including an ultraviolet curable resin.

7. The flexible display device of claim 6, wherein the second adhesive member includes third and fourth regions corresponding to the folding and peripheral regions, respectively, and
the ultraviolet curable resin of the third region has a conversion rate lower than a conversion rate of the ultraviolet curable resin of the fourth region.

## Patentansprüche

1. Flexible Anzeigevorrichtung, umfassend:
eine flexible Anzeigetafel (100), die einen Faltbereich (FA) und einen Randbereich (SA) beinhaltet;
ein erstes äußeres Element (200), das auf einer Oberfläche der flexiblen Anzeigetafel angeordnet ist;
und
ein erstes Klebeelement (200-A), das dazu eingerichtet ist, das erste äußere Element an der flexiblen Anzeigetafel zu befestigen, wobei das erste Klebeelement ein Ultraviolett-härtbares Harz und erste und zweite Bereiche (200-AF, 200-AS), die jeweils den Falt- und Randbereichen entsprechen, umfasst,
wobei das Ultraviolett-härtbare Harz des ersten Bereichs eine Umwandlungsrate aufweist, die niedriger ist als eine Umwandlungsrate des Ultraviolett-härtbaren Harzes des zweiten Bereichs.

2. Flexible Anzeigevorrichtung nach Anspruch 1, wobei die Umwandlungsrate des ultraviolett härtbaren Harzes des ersten Bereichs von etwa 50% bis etwa 80% und
die Umwandlungsrate des ultraviolett härtbaren Harzes des zweiten Bereichs von etwa 85% bis 100% reicht.

3. Flexible Anzeigevorrichtung nach Anspruch 2, wobei das Ultraviolett-härtbare Harz mindestens eines von einem Harz auf Urethanacrylat-Basis, einem Harz auf Epoxyacrylat-Basis, einem Harz auf Polyester-Basis oder einem Harz auf Polycarbonat-Basis beinhaltet.

4. Flexible Anzeigevorrichtung nach Anspruch 2 oder 3, wobei das erste Klebeelement eine Dicke im Bereich von etwa 10 µm bis etwa 200 µm aufweist.

5. Flexible Anzeigevorrichtung nach einem der Ansprüche 2 bis 4, wobei die flexible Anzeigetafel im Faltbereich mit einem Krümmungsradius von etwa 0,5 bis etwa 10 mm gefaltet ist.

6. Flexible Anzeigevorrichtung nach einem der Ansprüche 1 bis 5, ferner umfassend:
ein zweites äußeres Element, das auf einer anderen Oberfläche der flexiblen Anzeigetafel angeordnet ist; und
ein zweites Klebeelement, das das zweite äußere Element an der flexiblen Anzeigetafel befestigt und ein Ultraviolett-härtbares Harz beinhaltet.

7. Flexible Anzeigevorrichtung nach Anspruch 6, wobei das zweite Klebeelement dritte und vierte Bereiche beinhaltet, die den Falt- bzw. Randbereichen entsprechen, und
das Ultraviolett-härtbare Harz des dritten Bereichs eine Umwandlungsrate aufweist, die niedriger ist als die Umwandlungsrate des Ultraviolett-härtbaren Harzes des vierten Bereichs.

## Revendications

1. Dispositif d'affichage flexible comprenant :
un panneau d'affichage flexible (100) comprenant une région de pliage (FA) et une région périphérique (SA) ;
un premier élément extérieur (200) disposé sur une surface du panneau d'affichage flexible ; et
un premier élément adhésif (200-A) agencé de manière à attacher le premier élément extérieur au panneau d'affichage flexible, le premier élément adhésif comprenant une résine durcissable aux ultraviolets, et des première et deuxième régions (200-AF, 200-AS) correspondant respectivement aux régions de pliage et périphérique,
dans lequel la résine durcissable aux ultraviolets de la première région a un taux de conversion inférieur au taux de conversion de la résine durcissable aux ultraviolets de la deuxième région.

2. Dispositif d'affichage flexible selon la revendication 1, dans lequel le taux de conversion de la résine durcissable aux ultraviolets de la première région est situé dans la plage allant d'environ 50 % à environ 80 %, et
le taux de conversion de la résine durcissable aux ultraviolets de la deuxième région est situé dans la plage allant d'environ 85 % à 100 %.

3. Dispositif d'affichage flexible selon la revendication 2, dans lequel la résine durcissable aux ultraviolets comprend au moins l'une parmi une résine à base d'acrylate d'uréthane, une résine à base d'époxy-acrylate, une résine à base de polyester, et une résine à base de polycarbonate.

4. Dispositif d'affichage flexible selon la revendication 2 ou 3, dans lequel le premier élément adhésif a une épaisseur située dans la plage allant d'environ 10 µm à environ 200 µm.

5. Dispositif d'affichage flexible selon l'une quelconque des revendications 2 à 4, dans lequel le panneau d'affichage flexible est plié au niveau de la région de pliage avec un rayon de courbure d'environ 0,5 à environ 10 mm.

6. Dispositif d'affichage flexible selon l'une quelconque des revendications 1 à 5, comprenant en outre :
un deuxième élément extérieur disposé sur une autre surface du panneau d'affichage flexible ; et
un deuxième élément adhésif attachant le deuxième élément extérieur au panneau d'affichage flexible et comprenant une résine durcissable aux ultraviolets.

7. Dispositif d'affichage flexible selon la revendication 6, dans lequel le deuxième élément adhésif comprend des troisième et quatrième régions correspondant respectivement aux régions de pliage et périphérique, et
la résine durcissable aux ultraviolets de la troisième région a un taux de conversion inférieur au taux de conversion de la résine durcissable aux ultraviolets de la quatrième région.
